**Europäisches Patentamt**

**European Patent Office**

**Office européen des brevets**

(19)

(11) Veröffentlichungsnummer: **0 025 854**
**B1**

(12) **EUROPÄISCHE PATENTSCHRIFT**

(45) Veröffentlichungstag der Patentschrift:
**18.05.83**

(51) Int. Cl.³: **H 01 L 21/00,** H 01 L 29/10,
H 01 L 21/316

(21) Anmeldenummer: **80104758.0**

(22) Anmeldetag: **12.08.80**

(54) Verfahren zum Herstellen von bipolaren Transistoren.

(30) Priorität: **21.09.79 US 77699**

(43) Veröffentlichungstag der Anmeldung:
**01.04.81 Patentblatt 81/13**

(45) Bekanntmachung des Hinweises auf die Patenterteilung:
**18.05.83 Patentblatt 83/20**

(84) Benannte Vertragsstaaten:
**DE FR GB**

(56) Entgegenhaltungen:

FR-A-2 291 608
FR-A-2 316 732
FR-A-2 341 943
US-A-4 111 726
US-A-4 115 797

G. DEARNALEY et al.: «Ion implantation», 1973, North-Holland Publishing Cy, Amsterdam-London American Elsevier Publishing Cy, New York, US

(73) Patentinhaber: **International Business Machines Corporation, Armonk, N.Y. 10504 (US)**

(72) Erfinder: **Horng, Cheng Tzong, 22 Concord Road, Fishkill, NY 12524 (US)**
Erfinder: **Lilja, Harold Vinell, 8 Floral Road, Peekskill, NY 10566 (US)**
Erfinder: **Seto, David Kenroku, Barmore Road, LaGrangeville, NY 12540 (US)**

(74) Vertreter: **Böhmer, Hans Erich, Dipl.-Ing., Schönaicher Strasse 220, D-7030 Böblingen (DE)**

Verfahren zum Herstellen von bipolaren Transistoren

Die Erfindung betrifft ein Verfahren zum Herstellen bipolarer Transistoren mit Emitter-, Basis- und Kollektorzonen in einer integrierten Halbleiterschaltung in einem aus monokristallinem Silicium bestehenden Halbleiterkörper, bei welchem für die Bildung einer inaktiven Basiszone durch Ionenimplantation eine Sperrmaske aus Oxidmaterial verwendet wird, durch Bilden einer Subkollektorzone des ersten Leitungstyps in einem aus monokristallinem Silicium des zweiten Leitungstyps bestehenden Substrat, durch Bilden einer darüberliegenden epitaxialen Halbleiterschicht, in der eine mindestens die Subkollektorzone umschliessenden ringförmigen Isolationszone, eine eine zentrale Öffnung aufweisende inaktive Basiszone des zweiten Leitungstyps und eine Kollektorkontaktzone des ersten Leitungstyps gebildet werden, während die Emitterzone des ersten Leitungstyps und eine implantierte, darunterliegende aktive Basiszone des zweiten Leitungstyps aufeinanderfolgend in der zentralen Öffnung der inaktiven Basiszone in der epitaxialen Schicht selbstausrichtend gebildet werden.

Ein derartiges Verfahren ist beispielsweise aus der US-A-4 111 726 bekannt.

Zum Stand der Technik sei weiterhin genannt die US-A-3 986 897 in welcher ein Verfahren zur Behandlung der Aluminiummetallisierung von Halbleitern beschrieben ist, wobei die zu behandelnde Aluminiumoberfläche dafür 1 bis 10 Minuten bei Zimmertemperatur rauchender Salpetersäure ausgesetzt wird. Nach einer Reinigung wird die Oberfläche für 5 bis 15 Minuten kochendem Wasser ausgesetzt. Durch diese Behandlung scheint sich auf der Oberfläche des Aluminiums eine Schicht aus Böhmit (A10-OH) zu bilden, wodurch das sog. Hillocking im wesentlichen beseitigt wird.

Ferner sei auf die US-A-4 068 018 verwiesen. In dieser Patentschrift ist ein Verfahren zum Herstellen einer Maske, wie z.B. einer Photomaske für ein selektives Ätzverfahren bei der Herstellung von Halbleitervorrichtungen oder einer Schutzmaske in einem Verfahren für eine selektive Herstellung einer porösen Schicht aus Silicium oder für die anodische Oxidation einer Metallschicht offenbart, wobei auf eine vorbestimmte Geschwindigkeit beschleunigte Ionen in einen Photolackfilm bis zu einer vorbestimmten Dosierungsebene implantiert werden.

Ferner sei auf die US-A-4 089 709 verwiesen. In dieser Patentschrift ist ein Verfahren offenbart, durch das eine Aluminiumschicht, wie z.B. ein Verbindungsleitungsmuster auf einer integrierten Schaltung dadurch passiviert wird, dass die Aluminiumschicht zur Bildung einer dünnen Schicht aus amorphem Aluminiumoxid oxydiert wird. Die $Al_2O_3$-Schicht wird dann mit einem oberflächenaktiven Material zur Bildung einer hydrophoben Oberfläche auf der Aluminiumoxidschicht überzogen, wodurch die Bildung und das Aufwachsen von AlOOH auf der Oxidschicht verhindert wird. Die hydrophobe Oberfläche wird dann mit einem üblichen Passivierungsmaterial wie z.B. Siliciumdioxid, einem Epoxidharz oder einem ähnlichen Material überzogen.

Ferner sei auf die EP-A-78 101 265 entsprechend der US-A-4 118 250 hingewiesen, in der ein Verfahren zum Herstellen eines bipolaren Transistors offenbart ist, wobei alle Zonen oder Bereiche des Transistors mit Ausnahme der Emitterzone über eine Ionenimplantation durch eine anorganische dielektrische Schicht gleichförmiger Dicke erzeugt werden. Anschliessend werden alle Kontaktöffnungen nach der Emitterzone, der Basiszone und der Kollektorzone gebildet und dann wird die Emitterzone durch die Öffnung für den Emitterkontakt implantiert. Diese Kombination von Verfahrensschritten ermöglicht die Verwendung einer auf der Oberfläche liegenden isolierenden dielektrischen Schicht gleichförmiger Dicke, wobei alle Kapazitäten gleichförmig und kontrollierbar sind, während immer noch eine unmittelbare Implantation der Emitterzone möglich ist, die wegen ihrer geringen Tiefe nur schwer durch eine Oxidschicht hindurch implantiert werden kann.

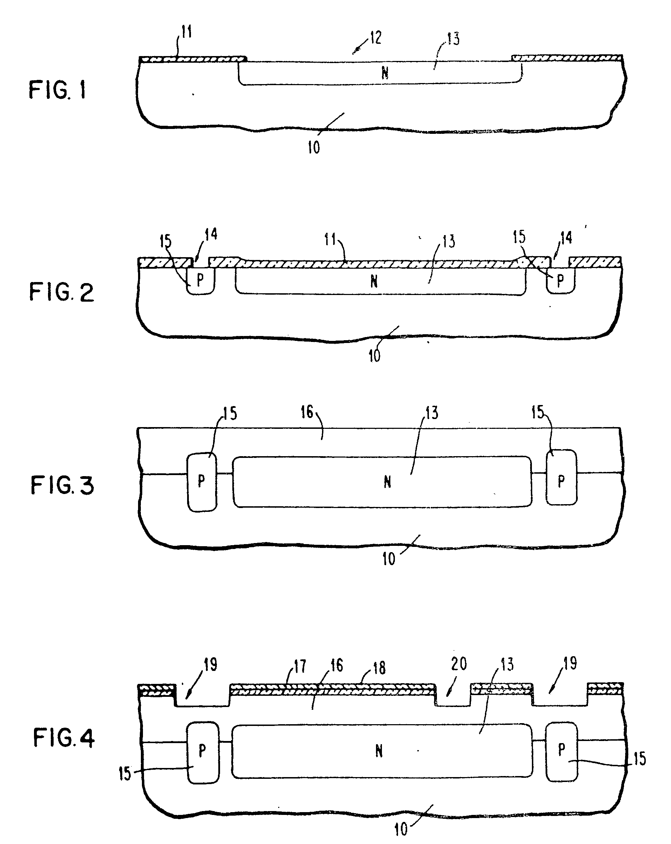

Ferner sei auf ein Anodisierverfahren hingewiesen, das in einer Veröffentlichung mit dem Titel «Identification of Crystal Defects Causing Diffusion Pipes» von D. K. Seto, F. Barson und B. F. Duncan in Semiconductor Silicon 1973, H. R. Huff und R. R. Burgess, Herausgeber, The Electrochemical Society Softbound Symposium Series, 1973, Seiten 651-657 enthalten, dort besprochen und schematisch in Fig. 1 dargestellt ist.

Ferner sei auf eine Veröffentlichung «Anodic Oxide Films on Aluminium» von J. W. Diggle, Chemical Reviews Vol. 69, 1969 Seiten 365-404 verwiesen.

In dem doppelt diffundierten bipolaren Transistor des Standes der Technik wird eine Basiszone durch eine selektive Diffusion in eine Kollektorzone gebildet, während eine sich nur teilweise in die Basiszone hineinerstreckende Emitterzone durch eine zweite Diffusion gebildet wird. Die Emitterdiffusion wird in vielen Anwendungsgebieten bei einer wesentlich höheren Temperatur durchgeführt, als die Basisdiffusion. Durch diesen Hoch-Temperatur-Diffusionszyklus findet eine Neuverteilung des zuvor durch die Basisdiffusion gebildeten Dotierungsprofils in der Basiszone statt.

Für einen vertikalen, bipolaren Transistor ist der unmittelbar unter der Emitterzone liegende Teil der Basiszone, die aktive Basiszone. Das Störelement-Dotierungsprofil und die Breite der aktiven Basiszone bestimmen den Emitter-Injektionswirkungsgrad, die Stromverstärkung und die Schaltgeschwindigkeit. Der Teil der Basiszone, der die Emitterzone umgibt, ist die inaktive Basiszone. Der metallische Kontakt mit der Basiszone wird dabei über der inaktiven Basiszone gebildet. Die Dotierung der inaktiven Basiszone bestimmt die Durchschlageigenschaften zwischen Emitter und Basis und dem äusseren Basiswiderstand.

Für ein gutes Hochfrequenzverhalten ist es wichtig, dass die Basiszone schmal ist, und dass die aktive Basiszone nur schwach dotiert ist. Es ist ferner wichtig, dass die inaktive Basiszone stark dotiert ist, wodurch der Reihenwiderstand der Basiszone und der Kontaktwiderstand zwischen Metall- und Basiszone herabgesetzt wird.

Bei den üblichen doppelt diffundierten bipolaren Transistoren wird die Kontrolle oder Überwachung der Dotierung der integrierten Basiszone in der aktiven Basiszone mit zunehmender Verringerung der Tiefe der einzelnen Halbleitervorrichtungen zur Erhöhung der Schaltgeschwindigkeit unter Beibehaltung eines niedrigen Flächenwiderstandes in der äusseren Basiszone immer schwieriger. Damit eine noch bessere Transistorstruktur erzielt werden kann, müssen die Störelementdotierungsprofile in der aktiven und in der inaktiven Basiszone durch getrennte voneinander unabhängige Verfahren genau gesteuert werden. Um eine genau steuerbare geringe Breite der Basiszone zu erzielen, ist es erwünscht, dass die aktive Basiszone «in situ» gebildet wird. Um dies zu erreichen, ist es notwendig, dass anstelle der üblichen thermischen Diffusionsverfahren für die Dotierung von inaktiven und aktiven Basiszonen Ionenimplantation benutzt wird.

Mit Hilfe der Ionenimplantation kann man die Menge der in die Halbleiterscheibe eingebrachten Störelemente sehr genau steuern. Die Verteilung der Störelemente in der Tiefe lässt sich durch die Implantationsenergie genau steuern. Ausserdem ist im Gegensatz zu den üblichen thermischen Diffusionsverfahren die Ionenimplantation kein bei hohen Temperaturen arbeitendes Verfahren. Eine Implantation in eine Siliciumscheibe kann durch eine auf der Oberfläche liegende Passivierungsschicht durchgeführt werden. Somit kann man unter Verwendung von Photolack oder Metallmasken verschiedene Störelemente in die Halbleiterscheibe einbringen ohne dabei auf bei hohen Temperaturen ablaufende Diffusionen zurückgreifen zu müssen. Eine abschliessende Wärmebehandlung reicht zum Anlassen und Beseitigen der durch die Implantation erzeugten Strahlungsschäden und zum Erzielen der gewünschten Tiefe des Übergangs aus. Dies hat zur Folge, dass bei Verwendung von Ionenimplantationsverfahren die integrierten Schaltungen flacher und mit einer grösseren Präzision der Störelementverteilung hergestellt werden können.

Die der Erfindung zugrundeliegende Aufgabe besteht also darin, ein Verfahren zum Herstellen einer Halbleitervorrichtung, insbesondere eines bipolaren Transistors mit viel guten Eigenschaften anzugeben, der eine durch Ionenimplantation gebildete sehr stark dotierte inaktive Basiszone und eine nur schwache, schmale, aktive Basiszone aufweist. Dabei muss verhindert werden, dass bei einer mit hoher Dosierung ablaufenden Borimplantation für einen NPN-Transistor diese in die aktive Basiszone gelangt. Daher ist für die Implantation der inaktiven Basiszone eine selbstausrichtende Maske erforderlich, die den Emitterkontakt, d.h. die aktive Basiszone überdeckt.

Dies wird erfindungsgemäss in der Weise erreicht, dass zur Bildung der selbstausrichtende Sperrmaske eine Aluminiumschicht über einer die Halbleiterschicht bedeckenden Isolierschicht einschliesslich der darin gebildeten Kontaktöffnungen niedergeschlagen und über den freiliegenden Halbleiter Kontaktzonen zu Aluminiumoxid selektiv anodisiert wird, worauf die nicht oxidierten Teile der Aluminiumschicht entfernt werden, und dass zunächst durch Ionenimplantation die inaktive Basiszone und nach Entfernen der Maske durch die in einem photolithographischen Verfahrensschritt erzeugte zentrale Ölffnung zunächst die Emitterzone und dann durch Ionenimplantation durch diese Emitterzone hindurch die aktive Basiszone gebildet werden. Die in diesem Verfahren verwendete selbstausrichtende Maske besteht also aus den anodisch oxydierten Aluminiumkontakten. Bei diesem Verfahren wird die vollständig mit einem Aluminiumfilm überzogene Halbleiterscheibe in eine mit wässriger $H_2SO_4$-Lösung gefüllte elektrolytische Zelle eingetaucht, wodurch selektiv nur die über den $Si_3N_4/SiO_2$ definierten Kontaktöffnungen liegenden Aluminiumkontakte anodisiert werden. Das durch das Anodisierverfahren gebildete Aluminiumoxid ist porös, kann jedoch abgedichtet und verdichtet werden. Die nicht anodisierte Aluminiumschicht wird dann entweder durch eine chemische Lösung oder durch Zerstäubungsätzen selektiv abgeätzt. Verwendet man das über den Kontaktöffnungen gebildete Aluminiumoxid für eine Maskierung der aktiven Basiszonen, dann kann man eine Borimplantation hoher Dosierung durch die $Si_3N_4/SiO_2$-Schichten zur Dotierung der inaktiven Basiszone durchführen. Nach Abziehen des Aluminiumoxids von der Kontaktöffnung für die Emitterzone, wird anschliessend die Emitterzone mit dem gewünschten Konzentrationsprofil und der entsprechenden Tiefe des Übergangs gebildet. Die aktive Basiszone wird durch eine Borimplantation niedriger Dosierung mit der höchsten Konzentration unterhalb der Emitterzone gebildet. Anschliessend wird bei relativ niedriger Temperatur, beispielsweise bei etwa 900°C, angelassen, wodurch das implantierte Bor voll aktiviert wird und die Neuverteilung des Dotierungsprofils der aktiven Basiszone kleingehalten wird. Die so gebildete Halbleitervorrichtung hat eine genau steuerbare, geringe Basisbreite und ein entsprechendes Dotierungsprofil.

Die Erfindung wird nunmehr anhand von Ausführungsbeispielen in Verbindung mit den beigefügten Zeichnungen im einzelnen mehr erläutert.

In den Zeichnungen zeigen Figuren 1 bis 12 Seitenansichten, zum Teil im Schnitt, der aufeinanderfolgenden Stufen des Herstellungsverfahrens gemäss der Erfindung.

Beschreibung der bevorzugten Ausführungsformen.

In Fig. 1 wird eine aus monokristallinem Silicium bestehende Halbleiterscheibe 10 zur Bildung einer Maskenschicht 11 oxidiert. Eine der Diffusion dienende Öffnung 12 wird unter Verwendung üblicher photolithographischer und subtraktiver Ätzverfahren zur Bildung eines Subkollektors in der Maskenschicht 11 gebildet. Anschliessend wird zur Bildung der Subkollektorzone 13 ein N-leitendes Störelement in die Halbleiterscheibe 10 eingebracht. Das Störelement kann irgendein geeignetes, N-Leitung hervorrufendes Störelement, beispielsweise Arsen, sein und kann entweder durch Diffusion oder Ionenimplantation in die Halbleiterscheibe eingebracht werden.

Wie aus Fig. 2 zu sehen ist, wird anschliessend die Oberfläche der Halbleiterscheibe zur Bildung einer Maskenschicht über der Subkollektorzone 13 reoxidiert. Dann werden Diffusionsöffnungen 14 für eine kreisringförmige Isolationszone durch übliche photolithographische und subtraktive Ätzverfahren hergestellt und anschliessend wird ein P-leitendes Störelement zur Bildung der Subisolationszone 15 eingebracht. Als Störelement wird vorzugsweise Bor durch Kapseldiffusion oder durch $BBr_3$-Diffusion eingebracht.

In Fig. 3 erkennt man, dass die Maskenschicht 11 entfernt ist, und dass auf der Oberfläche der Halbleiterscheibe 10 eine epitaxiale Siliciumschicht 16 darauf niedergeschlagen worden ist. Während des Epitaxialniederschlags, der bei hohen Temperaturen abläuft, diffundiert die Subkollektorzone 13 und die Subisolationszone 15 nach oben in die Schicht 16 ein.

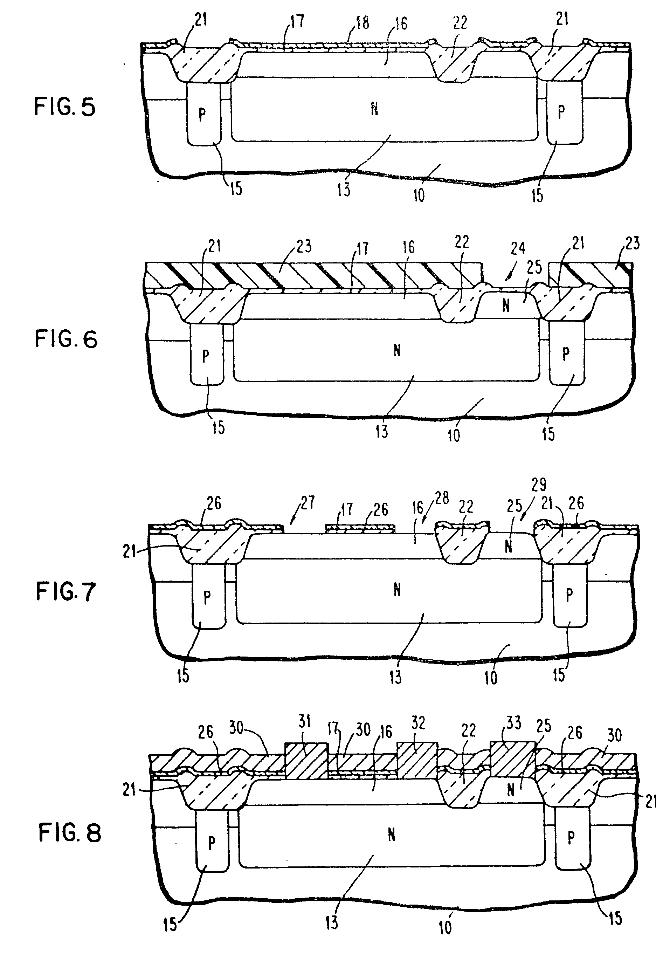

Anschliessend wird entsprechend Figur 4 die Epitaxialschicht 16 in einer oxidierenden Atmosphäre, beispielsweise bei Wasserdampf bei 950°C zur Bildung einer thermischen Oxidschicht 17 oxidiert. Anschliessend wird über der thermisch aufgewachsenen Oxidschicht 17 durch Niederschlag aus der Dampfphase in bekannter Weise eine Schicht 18 aus $Si_3N_4$ niedergeschlagen. Die aus $Si_3N_4$ bestehende Schicht 18 dient als Maske und verhindert die Oxidation der darunterliegenden Bereiche der epitaxial aufgewachsenen Schicht während der Bildung einer vertieft liegenden oxidierten Isolationszone, die noch beschrieben wird. Eine hier nicht dargestellte Photolackschicht wird dann über der aus $Si_3N_4$ bestehenden Schicht niedergeschlagen. Diese Photolackschicht wird dann belichtet und zur Bildung von Öffnungen entwickelt, die über der Subisolationszone 15 liegen. Ausserdem wird eine zweite Öffnung hergestellt mit der Folge, dass man eine Oxidzone erhält, die die Basiszone von dem Bereich trennt, der nach der Kollektorzone führt. Unter Verwendung eines Photolacks als Ätzmaske werden die freiliegenden Bereiche der darunterliegenden Schichten aus $Si_3N_4$ und $SiO_2$ durch reaktives Ionenätzen entfernt. Dies hat zur Folge, dass über der Subisolationszone 15 Öffnungen 19 gebildet werden, und eine weitere Öffnung 20, die über dem Bereich liegt, der den Kollektoranschlussbereich von der Basiszone des Transistors trennt. Anschliessend wird der in den Öffnungen 19 und 20 freiliegende Teil der epitaxial aufgewachsenen Schicht 16 durch subtraktives Ätzen oder reaktives Ionenätzen bis etwa zur Hälfte der Tiefe abgetragen, mit der sich die vergrabene Oxidzone in die epitaxial aufgewachsene Schicht hinein erstreckt. Wie in Fig. 5 gezeigt, wird dann die Halbleiterscheibe einer oxidierenden Atmosphäre ausgesetzt, mit der Folge, dass sich vertieft liegenden Oxidzonen 21 über der Subisolationszone 15 und dem Bereich 22 bilden, der den Kollektoranschluss von der Basiszone trennt. Die oxidierende Atmosphäre ist Wasserdampf bei etwa 1000°C.

Gemäss Fig. 6 wird die $Si_3N_4$-Schicht 18 entfernt und es wird auf der Oberfläche der Halbleiterscheibe eine Photolackschicht 23 niedergeschlagen. Diese Photolackschicht 23 wird belichtet und zur Bildung einer Öffnung 24 entwickelt, die über dem Kollektoranschluss liegt. Ein dafür geeignetes N-leitendes Störelement, vorzugsweise Phosphor, wird zur Bildung des Kollektoranschlusses 25 in die Epitaxialschicht 16 implantiert. Vorzugsweise wird die Phosphorimplantation bei einer hohen Energie, beispielsweise 400 KeV, durchgeführt, so dass eine gut leitende Verbindung nach dem darunterliegenden Subkollektor 13 hergestellt wird. Anschliessend wird die Photolackschicht 23 unter Verwendung eines $O_2$-Plasmas entfernt.

Wie aus Fig. 7 zu erkennen, wird anschliessend eine Schicht 26 aus $Si_3N_4$ über der Oxidschicht 17 niedergeschlagen. Anschliessend wird über der aus $Si_3N_4$ bestehenden Schicht 26 eine hier nicht gezeigte Photolackschicht niedergeschlagen, die dann belichtet und zur Herstellung einer Öffnung 27 für dem Emitterkontakt entwickelt wird sowie einer Öffnung 28 für den Basisanschluss und einer Öffnung 29 für den Kollektoranschluss. Die darunterliegenden, freiliegenden Bereiche der Schichten 26 und 17 werden vorzugsweise durch reaktives Ionenätzen entfernt, so dass man Kontaktöffnungen mit nahezu senkrechten Seitenwänden erhält.

Anschliessend wird gemäss Fig. 8 vorzugsweise durch Aufdampfen im Vakuum eine aus Aluminium bestehende Schicht 30 über der Hableiterscheibe niedergeschlagen. Die Dicke dieser aufgedampften Aluminiumschicht beträgt etwa 1 um. Die Halbleiterscheibe 10 wird dann von der Rückseite aus kontaktiert und dann als Anode wirkend in eine elektrolytische Zelle mit einer 5%igen $H_2SO_4$-Lösung eingetaucht. Eine aus einer Platinplatte bestehende Kathode kann als Gegenelektrode benutzt werden. Die für die Aluminiumanodisierung verwendete Spannung liegt zwischen etwa 2,5 bis 5,0 Volt. Die über den durch $Si_3N_4$ definierten Kontaktöffnungen 27, 28 und 29 liegende Aluminiumschicht 30 wird zur Bildung von Aluminiumoxidbereichen 31, 32 und 33 anodisiert. Das so gebildete Aluminiumoxid ist porös und kann durch Eintauchen in kochendes Wasser oder Wasserdampf abgedichtet und verdichtet werden. Der nicht anodisierte Teil der aus Aluminium bestehenden Schicht wird dann entweder durch subtraktives, nasses Ätzen oder durch Zerstäubungsätzen abgetragen.

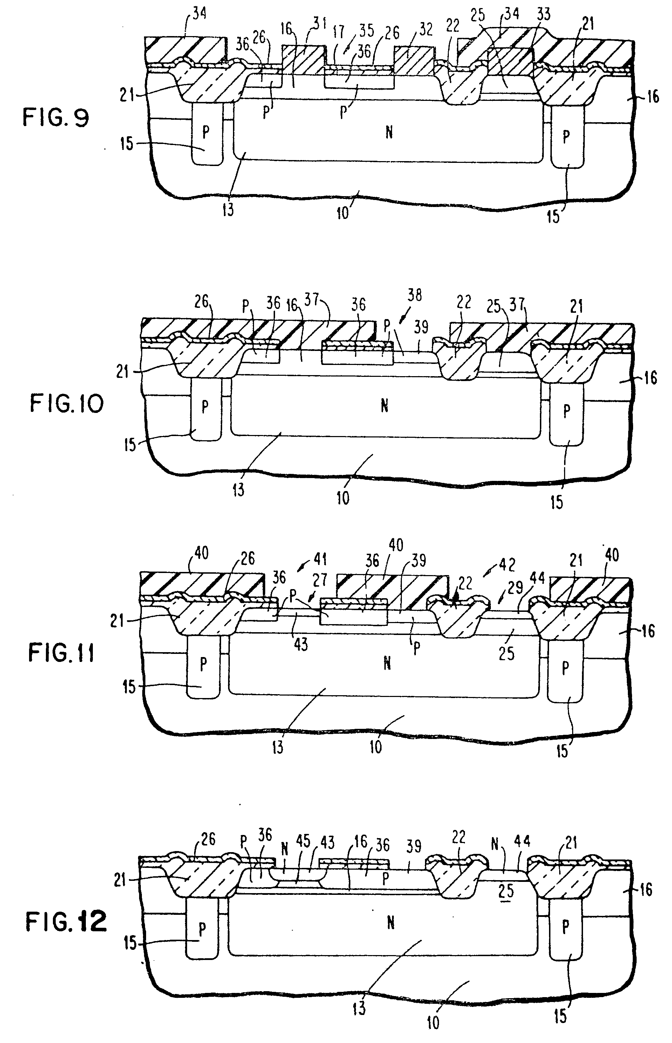

Gemäss Fig. 9 wird dann auf der Oberfläche der Halbleiterscheibe eine Photolackschicht 34 niedergeschlagen und anschliessend zur Bildung einer Öffnung 35 belichtet und entwickelt. Dann wird ein geeignetes P-leitendes Störelement, vorzugsweise Bor, durch die aus $Si_3N_4$ bestehende Schicht 26 und die aus $SiO_2$ bestehende Schicht 17 in die darunterliegende Epitaxialschicht 16 zur Bildung der äusseren Basiszone 36 implantiert. Die Dosierung für die Borimplantation liegt bei 2,0 bis 2,5 × $10^{14}$ je $cm^2$ und hat einen äusseren Flächenwiderstand der Basiszone von etwa 400 $\Omega/\square$ zur Folge. Zu diesem Zeitpunkt des Verfahrens können Widerstände (nicht gezeigt) in verschiedenen Teilen der Halbleitervorrichtung hergestellt werden. Nach der Borimplantation wird die Photolackschicht 34 und das Aluminiumoxid 31, 32 und 33 auf den Kontaktbereichen unter Verwendung einer warmen $H_2SO_4$-Lösung entfernt.

Entsprechend Fig. 10 wird auf der Oberfläche der Halbleiterscheibe eine Photolackschicht 37 aufgebracht und dann zur Erzeugung einer Öffnung 38, die über dem Basiskontakt 28 liegt, belichtet und entwickelt. Anschliessend wird ein dafür geeignetes Störelement, vorzugsweise Bor, durch die Öffnung 38 zur Bildung des Basiskontakts 39 implantiert. Die Borimplantation kann bei geringer Energie, von angenähert 30 bis 40 KeV mit einer Dosierung von rund 1 bis $2 \times 10^{14}$ je $cm^2$ durchgeführt werden. Zu diesem Zeitpunkt können die Widerstandsanschlüsse (nicht gezeigt) ebenfalls in verschiedenen Teilen der Halbleiterscheibe hergestellt werden. Anschliessend wird die Photolackmaske abgezogen.

Wie in Fig. 11 gezeigt, wird dann eine Photolackschicht 40 aufgebracht und zur Bildung von Öffnungen 41 und 42 belichtet und entwickelt, welche über den Emitter- und Kollektorkontaktbereichen liegt und den Basiskontakt 39 abdeckt. Ein dafür geeignetes N-leitendes Störelement, vorzugsweise Arsen, wird dann durch die Öffnungen 27 und 29 zur Bildung des Emitterkontakts 43 und des Kollektorkontakts 44 implantiert. Die Arsenimplantation wird mit einer Energie in der Grössenordnung von 40 KeV durchgeführt. Die Dosierung der Arsenimplantation liegt bei rund 2 bis $5 \times 10^{15}$ je $cm^2$. Die Photolackschicht wird entfernt und die Halbleitervorrichtung zur Aktivierung der implantierten Störelemente erwärmt, wobei gleichzeitig die Emitterzone 43, die Basiszonen 36 und 39 und die Kollektorzone 44 in die epitaxial aufgewachsene Schicht 16 hineingetrieben werden. Ein Anlassvorgang lässt das Siliciumgitter, das während der verchiedenen Ionenimplantationsschritte beschädigt worden ist, wieder zusammenwachsen.

Das Eintreiben der drei Zonen erfordert eine Erwärmung der Halbleiterscheibe auf eine Temperatur im Bereich zwischen 900 und 1100°C, vorzugsweise auf 1000°C. Die Anlasszeit hängt von der Dosierung der verschiedenen implantierten Zonen und der gewünschten Tiefe des Übergangs ab. Wie aus Fig. 12 zu erkennen, reicht die Emitterzone 43 tiefer in die Schicht 16 hinein. Gemäss Fig. 12 wird eine nicht gezeigte Photolackschicht niedergeschlagen und zur Bildung eines Fensters oberhalb der Emitterzone 43 belichtet und entwickelt. Dann wird die aktive Basiszone 45 des Transistors durch eine niedrig dosierte Borimplantation gebildet. Die Borimplantation wird dabei in die epitaxial aufgewachsene Schicht 16 hinein vorgenommen, wobei die maximale Konzentration unterhalb der Emitterzone 43 liegt, und die Implantation beispielsweise bei einer Energie in der Grössenordnung von 40 bis 50 KeV mit einer Dosierung im Bereich von 0,5 bis $2 \times 10^{13}$ je $cm^2$ durchgeführt wird. Zu diesem Zeitpunkt können die Widerstände mit hohen Werten im Bereich von 2000 bis 4000 $\Omega/\square$ ebenfalls hergestellt werden. Nach der Implantation wird die Photolackschicht abgezogen und die Halbleiterscheibe zur Aktivierung des implantierten Bors auf 900°C erwärmt. Eine Erwärmung oder ein Anlassvorgang bei 900°C hat eine volle Aktivierung des implantierten Bors zur Folge und bewirkt nur eine geringe Neuverteilung des Dotierungsprofils.

Die in Fig. 12 dargestellte Halbleiterscheibe kann nunmehr weiterbehandelt werden für den Niederschlag und die Hertellung der Metallisierung, die die Verbindungen zwischen den dargestellten Halbleitervorrichtungen und anderen Bauelementen, Widerständen und dergleichen auf dem gleichen Substrat 10 zu elektrischen Schaltungen herstellen. Die Bildung einer Metallisierung ist bekannt und soll hier nicht beschrieben werden. Es sei jedoch klargestellt, dass die hier in den Fig. 1 bis 12 gezeigte bevorzugte Ausführungsform ein NPN-Transistor ist. Selbstverständlich können die Leitungstypen auch umgekehrt und die Störelemente entsprechend verändert werden.

**Patentanspruch**

Verfahren zum Herstellen bipolarer Transistoren mit Emitter-, Basis- und Kollektorzonen in einer integrierten Halbleiterschaltung in einem aus monokristallinem Silicium bestehenden Halbleiterkörper, bei welchem für die Bildung einer inaktiven Basiszone durch Ionenimplantation eine Sperrmaske aus Oxidmaterial verwendet wird, durch Bilden einer Subkollektorzone des ersten Leitungstyps in einem aus monokristallinem Silicium des zweiten Leitungstyps bestehenden Substrat, durch Bilden einer darüberliegenden epitaxialen Halbleiterschicht, in der eine mindestens die Subkollektorzone umschliessenden ringförmigen Isolationszone, eine eine zentrale Öffnung aufweisende inaktive Basiszone des zweiten Leitungstyps und eine Kollektorkontaktzone des ersten Leitungstyps gebildet werden, während die Emitterzone des ersten Leitungstyps und eine implantierte, darunterliegende aktive Basiszone des zweiten Leitungstyps aufeinanderfolgend in der zentralen Öffnung der inaktiven Basiszone in der epitaxialen Schicht selbstausrichtend gebildet werden, dadurch gekennzeichnet, dass zur Bildung der selbstausrichtenden Sperrmaske eine Aluminiumschicht (30) über einer die Halbleiterschicht bedeckenden Isolierschicht einschliesslich der darin gebildeten Kontaktöffnungen (27, 28, 29) niedergeschlagen und über den freiliegenden Halbleiterkontaktzonen zu Aluminiumoxid selektiv anodisiert wird, worauf die nicht oxidierten Teile der Aluminiumschicht entfernt werden, und dann zunächst durch Ionenimplantation die inaktive Basiszone (36) und nach Entfernen der Maske durch die in einem photolithographischen Verfahrensschritt erzeugte zentrale Öffnung zunächst die Emitterzone und dann durch Ionenimplantation durch diese Emitterzone hindurch die aktive Basiszone (45) gebildet werden.

**Revendication**

Procédé pour la réalisation de transistors bipolaires comportant des zones de collecteur à émetteur-base dans un circuit intégré à semi-conducteurs, dans un corps semi-conducteur composé de silicium monocristallin, où on utilise, pour créer une région de base inactive, par implantation ionique, un masque de blocage en matière isolante, en formant une zone de sous-collecteur du premier type de condutction dans un substrat en silicium monocristallin du second type de conduction en formant une couche semi-conductrice épitaxiale superposée, dans laquelle sont réalisées: une zone d'isolation annulaire entourant au moins la zone de sous-collecteur, une région de base inactive du second type de conduction présentant une ouverture centrale, et une zone de contact de collecteur du premier type de conduction, alors que la zone d'émetteur du premier type de condutction et une région de base active, du second type de conduction, implantée en-dessous, sont créées successivement dans l'ouverture centrale de la région de base inactive dans la couche épitaxiale, de manière à obtenir un auto-alignement, procédé caractérisé en ce que, pour former le masque de blocage à auto-alignement, on dépose une couche d'aluminium (30) au-dessus d'une couche isolante recouvrant la couche semi-conductrice y compris sur les ouvertures de contact (27, 28, 29) qui y sont pratiquées, que cette couche d'aluminium est, sélectivement, anodisée en oxyde d'aluminium au-dessus des zones de contact semi-conductrices exposées, les parties non oxydées de la couche d'aluminium étant enlevées, et en ce que l'on crée, d'abord, par implantation ionique, la région de base inactive (36) puis, après avoir enlevé le masque, à travers l'ouverture centrale réalisée lors d'une phase du procédé photolithographique, la zone d'émetteur et, enfin, par implantation ionique à travers cette zone d'émetteur, la région de base active (45).

## Claim

Method of making bipolar transistors with emitter, base, and collector regions in an integrated semiconductor circuit in a semiconductor body consisting of monocrystalline silicon, where for forming an inactive base region through ion implantation a blocking mask of oxide material is used, by forming a subcollector region of the first conductivity type in a substrate consisting of monocrystalline silicon of the second conductivity type, by forming a superimposed epitaxial semiconductor layer where an annular isolation region encompassing at least the subcollector region, an inactive base region of the second conductivity type with a central opening and a collector contact region of the first conductivity type are formed, whereas the emitter region of the first conductivity type and an implanted active base region of the second conductivity type therebeneath are successively formed in self-alignment in the central opening of the inactive base region in the epitaxial layer,

characterized in that for forming the self-alignment blocking mask an aluminium layer (30) is deposited over an isolation layer covering the semiconductor layer, including contact openings (27, 28, 29) therein, and selectively anodized to aluminum oxide over the exposed semiconductor contact regions, after which the non-oxidized parts of the aluminium layer are removed, and that first by ion implantation the inactive base region (36), and after the removal of the mask through the central opening produced in a photolithographic process step first the emitter region, and subsequently by ion implantation through this emitter region the active base region (45) are made.

FIG. 1

FIG. 2

FIG. 3

FIG. 4

FIG. 5

FIG. 6

FIG. 7

FIG. 8

**FIG. 9**

**FIG. 10**

**FIG. 11**

**FIG. 12**